# EUROPÄISCHE PATENTANMELDUNG

(11) **EP 4 513 204 A1**
(43) Veröffentlichungstag der Anmeldung: **26.02.2025**
(21) Anmeldenummer: 23192609.8
(22) Anmeldetag: 22.08.2023
(51) Int. Cl.: G01R 31/28, G01R 31/396

(54) **BATTERIESIMULATOR MIT REDUZIERTEM BEDARF AN ELEKTRISCHEN BAUELEMENTEN**

(71) Anmelder: dSPACE GmbH, 33102 Paderborn (DE)
(72) Erfinder: Hankeln, Lars, 33102 Paderborn (DE); Gruber, Paul, 33102 Paderborn (DE)

(57) **Zusammenfassung**

Batteriesimulator, umfassend eine erste elektrische Schaltung zur Bereitstellung einer ersten Zellspannung zur Simulation der elektrischen Spannung einer ersten Batteriezelle und eine zweite elektrische Schaltung zur Bereitstellung einer zweiten Zellspannung zur Simulation der elektrischen Spannung einer zweiten Batteriezelle. Die erste Zellspannung ist auf eine lokale Schaltungsmasse gelegt, und die zweite Zellspannung ist ist auf dieselbe lokale Schaltungsmasse gelegt und zu der ersten Zellspannung derart in Reihe geschaltet, dass die lokale Schaltungsmasse einen Pol der ersten Zellspannung und der zweiten Zellspannung ausbildet. Eine Steuerelektronik ist zur Regelung der ersten Zellspannung und der zweiten Zellspannung eingerichtet. Durch die Ansteuerung zweier Zellspannungen durch eine einzige Steuerelektronik ergibt sich eine Einsparung von Bauelementen.

## Beschreibung

Ein Batteriesimulator ist ein Entwicklungssystem, das im Stand der Technik eingesetzt wird, um die Performanz eines technischen Systems zu testen, das für die Wechselwirkung mit einer Batterie vorgesehen ist. Das technische System kann beispielsweise ein Batteriemanagementsystem sein, das den Lade- und Entladevorgang der Zellen einer Batterie steuert, ein aus einer Batterie gespeister Elektromotor eines E-Fahrzeugs, oder eine Ladesäule.

Eine Batterie umfasst eine Vielzahl in Reihe geschalteter Batteriezellen. Jede Batteriezelle ist eine galvanische Zelle, die eine individuelle Zellspannung erzeugt, sodass die Summe aller Zellspannungen die Ausgangsspannung der Batterie ergibt. Dementsprechend stellt ein im Stand der Technik bekannter Batteriesimulator eine Anzahl in Reihe geschalteter simulierter, individuell regelbarer Zellspannungen bereit und umfasst außerdem ein Computermodell, das für jede simulierte Zellspannung das elektrische Verhalten einer galvanischen Zelle simuliert, um eine Sollvorgabe für die jeweilige Zellspannung zu berechnen.

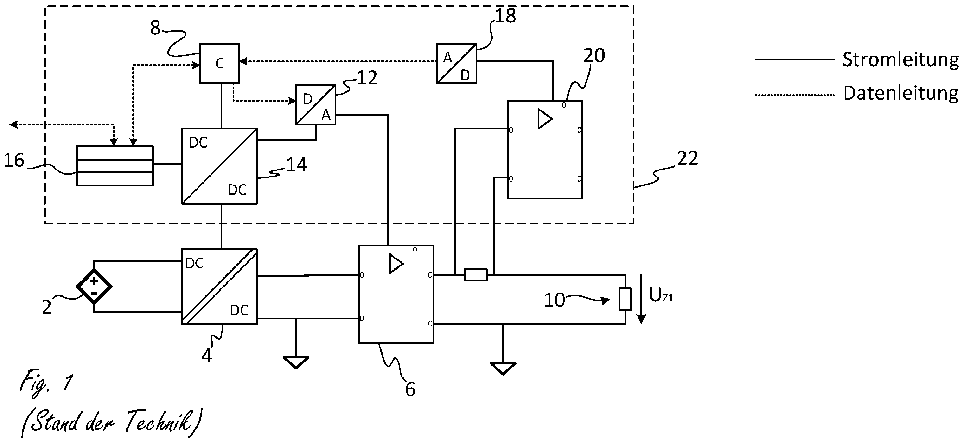

Die Abbildung der Figur 1 zeigt vereinfacht den Aufbau einer einzelnen simulierten Batteriezelle in einem Batteriesimulator gemäß Stand der Technik aus dem Produktportfolio der Anmelderin. Ein Gleichspannungswandler stellt eine Versorgungsspannung für den Betrieb der elektrischen Komponenten bereit, ein Spannungsregler legt an einen dafür vorgesehen Teilabschnitt der zugrundeliegenden elektrischen Schaltung die simulierte Zellspannung an und regelt sie auf einen Sollwert, der von einer Steuerelektronik vorgegeben wird. Die Steuerelektronik umfasst unter anderem Messtechnik, einen digitalen Isolator, einen Mikrocontroller und eine Hilfsspannungsversorgung. Wie erwähnt ist ein typischer Batteriesimulator ausgestaltet, um eine große Anzahl von Batteriezellen zu simulieren, wodurch in entsprechender Anzahl auch alle Einzelkomponenten der in der Figur 1 dargestellten elektrischen Schaltung verbaut sind. Insgesamt ergibt sich dadurch ein hoher Bedarf an elektrischen Bauelementen, der zu einem hohen Preis und einem großen Raumbedarf des Batteriesimulators führt.

Die Aufgabe der Erfindung besteht vor diesem Hintergrund darin, den Bedarf an elektrischen Bauelementen zum Aufbau eines Batteriesimulators zu reduzieren.

Zur Lösung der Aufgabe wird ein Batteriesimulator vorgeschlagen, der eine erste elektrische Schaltung umfasst. Über einen ersten Teilabschnitt der elektrischen Schaltung fällt eine erste Zellspannung zur Simulation der elektrischen Spannung einer ersten Batteriezelle ab. Die elektrische Schaltung umfasst weiterhin eine Steuerelektronik zur Regelung der ersten Zellspannung.

Die erste Zellspannung ist auf eine lokale Schaltungsmasse gelegt. Über einen zweiten Teilabschnitt der ersten elektrischen Schaltung fällt eine zweite Zellspannung zur Simulation der elektrischen Spannung einer zweiten Batteriezelle ab. Die zweite Zellspannung wird ebenfalls durch die Steuerelektronik geregelt und ist auf dieselbe lokale Schaltungsmasse gelegt wie die erste Zellspannung. Die zweite Zellspannung ist zu der ersten Zellspannung derart in Reihe geschaltet, dass die lokale Schaltungsmasse einen Pol der ersten Zellspannung und der zweiten Zellspannung ausbildet.

Die lokale Schaltungsmasse stellt für beide simulierten Zellspannungen, die erste Zellspannung und die zweite Zellspannung, ein wohldefiniertes gemeinsames Nullpotential dar. Unter einer lokalen Schaltungsmasse ist eine Masse gemäß dem aus der Elektrotechnik bekannten Fachbegriff zu verstehen, die aber keine globale Masse des Batteriesimulators darstellt, sondern lokal innerhalb der ersten elektrischen Schaltung zu dem Zweck implementiert ist, um, insbesondere exklusiv, für die erste Zellspannung und für die zweite Zellspannung als gemeinsames Nullpotential zu dienen.

Eine im Stand der Technik bekannte elektrische Schaltung zur Simulation einer Batteriezelle, wie zuvor beschrieben und in der Figur 1 dargestellt, kann eine einzige Batteriezelle simulieren. Demgegenüber kann die erfindungsgemäße erste elektrische Schaltung zwei Batteriezellen simulieren und benötigt für die Simulation der zweiten Batteriezelle nur einen geringfügig höheren Mehraufwand an elektrischen Bauelementen zur Anlegung der zweiten Zellspannung. Die zwei Zellspannungen teilen sich die elektrischen Bauelemente der Steuerelektronik sowie die Spannungsquelle für die Versorgungsspannung. Insgesamt ergibt sich demnach für einen erfindungsgemäßen Batterieemulator eine wesentlich effizientere Nutzung elektrischer Bauelemente. In einem Batterieemulator, der eine Vielzahl von Batteriezellen anhand mehrerer erfindungsgemäßer elektrischer Schaltungen simuliert, ist der Bedarf an Steuerelektroniken und lokalen Spannungsversorgungen gegenüber dem Stand der Technik halbiert.

Die erste elektrische Schaltung umfasst vorteilhaft eine eigene lokale Spannungsquelle, insbesondere einen Gleichspannungswandler, die angeordnet ist, eine Versorgungsspannung für den Betrieb der elektrischen Bauelemente der ersten elektrischen Schaltung an die erste elektrische Schaltung anzulegen. Weiterhin vorteilhaft umfasst die erste elektrische Schaltung einen von der Versorgungsspannung gespeisten ersten Spannungsregler, der angeordnet und ausgestaltet ist, die erste Zellspannung an den ersten Teilabschnitt anzulegen und auf einen ersten Sollwert zu regeln, und einen zweiten Spannungsregler, der angeordnet und ausgestaltet ist, die zweite Zellspannung an den zweiten Teilabschnitt anzulegen und auf einen zweiten Sollwert zu regeln.

Da sowohl die erste Zellspannung als auch die zweite Zellspannung an der lokalen Schaltungsmasse anliegen, ist es aus Symmetriegründen sinnvoll, eine der beiden Zellspannungen umzukehren. Wenn also beispielsweise eine als positiv definierte erste Zellspannung in Richtung der lokalen Schaltungsmasse gerichtet ist, dann sollte eine als positiv definierte zweite Zellspannung von der lokalen Schaltungsmasse fortgerichtet sein. Zu diesem Zweck umfasst die erste elektrische Schaltung vorteilhaft einen von der Versorgungsspannung gespeisten, zum ersten Spannungsregler parallelgeschalteten Inverswandler, wobei der zweite Spannungsregler von der Ausgangsspannung des Inverswandlers gespeist wird. Die Steuerelektronik ist eingerichtet, dem ersten Spannungsregler den ersten Sollwert derart vorzugeben, dass der erste Sollwert gleich einer Sollvorgabe für die elektrische Spannung der ersten Batteriezelle ist, und dem zweiten Spannungsregler den zweiten Sollwert derart vorzugeben, dass der zweite Sollwert gleich dem Negativwert einer Sollvorgabe für die elektrische Spannung der zweiten Batteriezelle ist. Beide Sollvorgaben können beispielsweise durch das zuvor genannte Computermodell zur Simulation des elektrischen Verhaltens einer Anzahl galvanischer Zellen vorgegeben sein.

Um mehr als nur zwei Batteriezellen simulieren zu können, umfasst der Batteriesimulator bevorzugt neben der ersten elektrischen Schaltung zumindest noch eine zweite elektrische Schaltung, die identisch zur ersten elektrischen Schaltung ausgestaltet ist und auf gleiche Weise wie zuvor beschrieben eine dritte Zellspannung bereitstellt, um die elektrische Spannung einer dritten Batteriezelle zu simulieren, und eine vierte Zellspannung bereitstellt, um die elektrische Spannung einer vierten Batteriezelle zu simulieren. Die zweite elektrische Schaltung ist mit der ersten elektrischen Schaltung derart elektrisch verbunden, dass die erste Zellspannung, die zweite Zellspannung, die dritte Zellspannung und die vierte Zellspannung in Reihe geschaltet sind, um gemeinsam vier in Reihe geschaltete Batteriezellen zu simulieren. Auf gleiche Weise kann der Batteriesimulator eine grundsätzlich beliebige Anzahl elektrischer Schaltungen umfassen, die alle identisch zur ersten elektrischen Schaltung ausgestaltet sind und derart miteinander elektrisch verbunden sind, dass alle durch die Anzahl elektrischer Schaltungen simulierten Zellspannungen in Reihe geschaltet sind, um eine Vielzahl in Reihe geschalteter Batteriezellen einer Batterie zu simulieren.

Die Erfindung wird nachfolgend anhand der Zeichnungen näher erläutert. Es zeigen
- Figur 1: als vereinfachtes Blockschaltbild eine aus dem Stand der Technik bekannte elektrische Schaltung zur Simulation einer einzelnen Batteriezelle in einem Batteriesimulator,
- Figur 2: als vereinfachtes Blockschaltbild eine erfindungsgemäße elektrische Schaltung zur Simulation zweier Batteriezellen in einem Batteriesimulator, und
- Figur 3: ein detailliertes Schaltbild der in der Figur 2 dargestellten elektrischen Schaltung.

Die Abbildung der Figur 1 illustriert in Form eines Blockschaltbildes eine aus dem Stand der Technik bekannte elektrische Schaltung zur Simulation einer ersten Batteriezelle in einem Batteriesimulator. Ein von einer globalen Spannungsversorgung 2 des Batteriesimulators gespeister Gleichspannungswandler stellt als Spannungsquelle 4 eine Versorgungsspannung für einen ersten Spannungsregler 6 bereit. Der erste Spannungsregler 6 ist angeordnet und ausgestaltet, um eine erste Zellspannung U_{Z1} an einen ersten Teilabschnitt 10 der elektrischen Schaltung anzulegen. Ein Mikrocontroller 8 gibt unter Vermittlung eines Digital-Analog-Wandlers 12 dem ersten Spannungsregler 6 einen ersten Sollwert für die erste Zellspannung U_{Z1} vor, und der erste Spannungsregler 6 ist ausgestaltet, die erste Zellspannung U_{Z1} auf den ersten Sollwert zu regeln. Der Mikrocontroller kommuniziert über einen digitalen Isolator 16 mit einem außerhalb der elektrischen Schaltung implementierten Computermodell zur Simulation des elektrischen Verhaltens einer Anzahl galvanischer Zellen einer Batterie, erhält von dem Computermodell eine Sollvorgabe für die erste Zellspannung U_{Z1} und gibt die Sollvorgabe als Sollwert an den ersten Spannungsregler 6 weiter.

Ein Differenzverstärker 20 ist angeordnet, um die Stromstärke des durch den ersten Teilabschnitt 10 fließenden Stroms zu messen und die gemessene Stromstärke unter Vermittlung eines Analog-Digital-Wandlers 18 an den Mikrocontroller 8 weiterzuleiten. Der Mikrocontroller 8 leitet den Istwert der Stromstärke über den digitalen Isolator 16 an den Batteriesimulator weiter.

Die elektrische Schaltung umfasst demnach eine Vielzahl elektrischer Bauelemente, die gemeinsam eine Steuerelektronik 22 zur Regelung der ersten Zellspannung U_{Z1} und zur Messung der von der ersten Zellspannung U_{Z1} induzierten Stromstärke ausbilden. Die Steuerelektronik umfasst unter anderen den digitalen Isolator 16, den Mikrocontroller 8, den Digital-Analog-Wandler 12, den Analog-Digital-Wandler 18, den Differenzverstärker 20 sowie eine Hilfsspannungsversorgung 14 zur Bereitstellung einer Betriebsspannung für die elektrischen Bauelemente der Steuerelektronik 22.

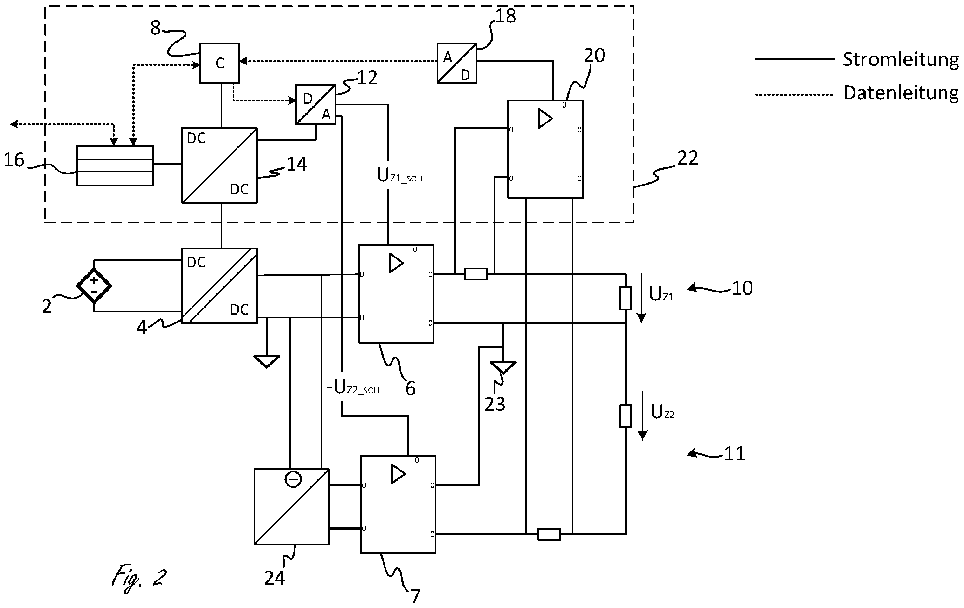

Die Abbildung der Figur 2 zeigt eine elektrische Schaltung zur Simulation der ersten Zellspannung U_{Z1} und einer zweiten Zellspannung U_{Z2} gemäß einer beispielhaften Ausgestaltung der Erfindung. Im Nachfolgenden werden nur die Unterschiede zu der in der Figur 1 dargestellten elektrischen Schaltung beschrieben.

Ein von der Spannungsversorgung 4 gespeister Inverswandler 24 ist dem ersten Spannungsregler 6 parallelgeschaltet, invertiert die von der Spannungsversorgung 4 bereitgestellte elektrische Spannung und speist mit der invertierten Spannung einen zweiten Spannungsregler 7. Der zweite Spannungsregler 7 ist angeordnet und ausgestaltet, eine zweite Zellspannung U_{Z2} an einen zweiten Teilabschnitt 11 der elektrischen Schaltung anzulegen. Der Mikrocontroller erhält auf analoge Weise wie zuvor beschrieben von dem Computermodell eine zweite Sollvorgabe für die zweite Zellspannung U_{Z2} und die gibt auf Basis der Sollvorgabe einen zweiten Sollwert für die zweite Zellspannung U_{Z2} an den zweiten Spannungsregler weiter, wobei die Steuerelektronik 22 aber eingerichtet ist, den zweiten Sollwert gegenüber der Sollvorgabe aus dem Computermodell zu invertieren. Der zweite Spannungsregler erhält als zweiten Sollwert also den Negativwert der zweiten Zellspannung U_{Z2}, den das Computermodell als zweite Sollvorgabe vorgibt.

Sowohl die erste Zellspannung UZ1 als auch die zweite Zellspannung UZ2 sind auf eine gemeinsame lokale Schaltungsmasse 23 gelegt, die somit ein wohldefiniertes gemeinsames Nullpotential für die erste Zellspannung U_{Z1} und die zweite Zellspannung U_{Z2} ausbildet. Durch die Invertierung der an den zweiten Spannungsregler 7 angelegten Spannung durch den Inverswandler 24 und die Invertierung des zweiten Sollwerts wird erreicht, dass eine als positiv definierte zweite Zellspannung U_{Z2} von der lokalen Schaltungsmasse 23 fortgerichtet ist, während eine als positiv definierte erste Zellspannung U_{Z1} in die lokale Schaltungsmasse 23 hineingerichtet ist.

Der Differenzverstärker 20 ist angeordnet und eingerichtet, zusätzlich die Stromstärke des durch den zweiten Teilabschnitt 11 fließenden Stroms zu messen und die gemessene Stromstärke auf analoge Weise wie zuvor beschrieben zur Weiterleitung an den Batteriesimulator an den Mikrocontroller 8 weiterzuleiten.

In der Abbildung ist leicht zu erkennen, dass für die Bereitstellung der zweiten Zellspannung U_{Z2} nur ein geringer Mehraufwand an elektrischen Bauelementen vonnöten ist. Der Mehraufwand beschränkt sich im Wesentlichen auf den Inverswandler 24, den zweiten Spannungsregler 7 und einen weiteren Messwiderstand. In einem Batteriesimulator lassen sich mehrere elektrische Schaltungen wie beispielsweise die in der Figur 2 dargestellte derart miteinander verschalten, dass alle von den mehreren elektrischen Schaltungen simulierten Zellspannungen in Reihe geschaltet sind, sodass sich insgesamt eine lange Reihenschaltung unabhängig voneinander regelbarer simulierter Zellspannungen ergibt. In einem herkömmlichen Batteriesimulator gemäß Stand der Technik wäre dabei jeder einzelnen Zellspannung eine eigene Steuerelektronik 22 sowie eine eigene Spannungsquelle 4 zugeordnet. In einem erfindungsgemäßen Batteriesimulator teilen sich jeweils zwei Zellspannungen eine Steuerelektronik 22 und eine Spannungsquelle 4. In einem Batteriesimulator, der für die Simulation einer Vielzahl von Batteriezellen ausgestaltet ist, ergibt sich dadurch eine wesentliche Einsparung von elektrischen Bauelementen.

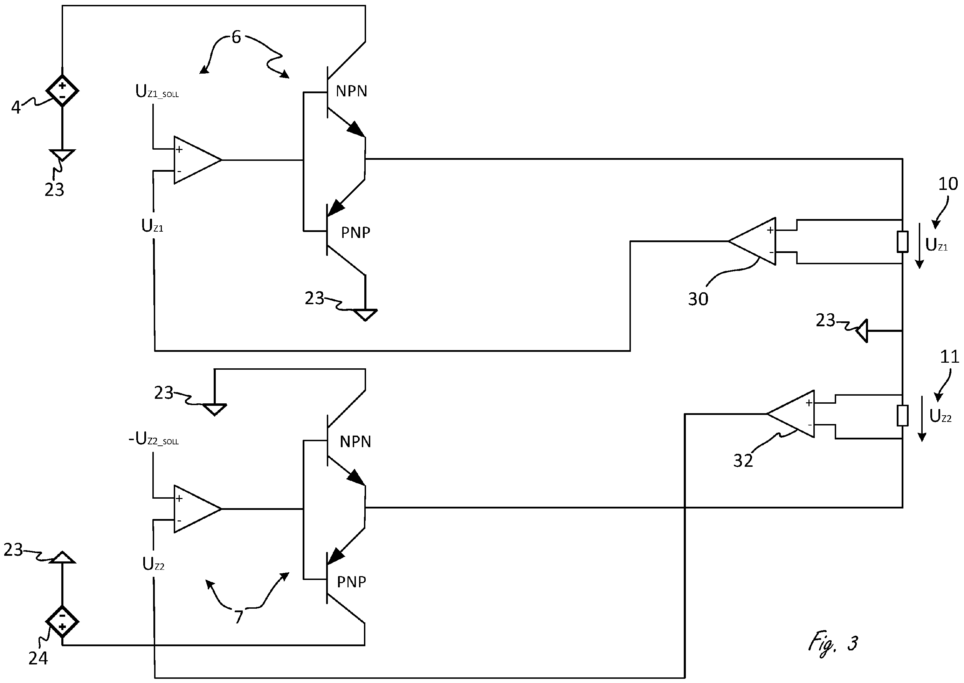

Die Abbildung der Figur 3 zeigt ein detaillierteres Schaltbild der ersten elektrischen Schaltung unter Auslassung der Steuerelektronik 22. Ein als Differenzverstärker ausgebildeter erster Spannungsmesser 30 misst die über den ersten Teilabschnitt abfallende erste Zellspannung U_{Z1}. Der erste Spannungsregler 6 umfasst einen Fehlerverstärker (error amplifier), an dessen erstem Eingang der vom ersten Spannungsmesser 30 ausgegebene Istwert der ersten Zellspannung U_{Z1} anliegt und an dessen zweitem Eingang der von dem Digital-Analog-Wandler 12 ausgegebene Sollwert der ersten Zellspannung U_{Z1} anliegt. Die Ausgangsspannung des Differenzverstärkers liegt jeweils als Basisspannung an einem von zwei Transistoren an, von denen einer als NPN-Transistor und einer als PNP-Transistor ausgestaltet ist. Die jeweilige Emitter-Kollektor-Spannung beider Transistoren ist durch die Spannungsquelle 4 angelegt.

Sobald der Mikrocontroller 8 den Sollwert für U_{Z1} ändert, stellt sich eine Differenz zwischen Sollwert und Istwert von U_{Z1} ein, die den Fehlerverstärker veranlasst, die an dem NPN-Transistor und die an dem PNP-Transistor anliegende Basisspannung anzupassen. Der Fehlerverstärker ist eingerichtet, die Basisspannung zu erhöhen, wenn der Sollwert von U_{Z1} höher ist als der Istwert, und die Basisspannung zu verringern, wenn der Sollwert von U_{Z1} niedriger ist als der Istwert. Je nachdem, ob der Mikroprozessor 8 den Sollwert für U_{Z1} erhöht oder erniedrigt, erhöht sich entweder der Widerstand des NPN-Transistors, und der Widerstand des PNP-Transistors erniedrigt sich, oder umgekehrt.

Da immer nur einer der beiden Transistoren, entweder der NPN-Transistor oder der PNP-Transistor leitend geschaltet ist, liegt eine elektrische Trennung von simulierten Ladestrom und simuliertem Entladestrom vor, sodass beide unabhängig voneinander messbar sind. Der über den NPN-Transistor führende Strompfad bildet den Entladestrom der ersten Batteriezelle ab, der über den PNP-Transistor führende Strompfad den Ladestrom der ersten Batteriezelle.

Der Regelkreis für die zweite Zellspannung U_{Z2} mit dem zweiten Spannungsregler 7 und einem zweiten Spannungsmesser 32 ist analog aufgebaut, wobei aber wegen der gegenüber der ersten Zellspannung U_{Z1} umgekehrten Polarität der zweiten Zellspannung U_{Z2} der NPN-Transistor und der PNP-Transistor funktional vertauscht sind. Der über den NPN-Transistor führende Strompfad bildet den Ladestrom der zweiten Batteriezelle ab, der über den PNP-Transistor führende Strompfad den Entladestrom der zweiten Batteriezelle.

## Patentansprüche

1. Batteriesimulator, umfassend eine erste elektrische Schaltung mit einer über einen ersten Teilabschnitt der ersten elektrischen Schaltung abfallenden ersten Zellspannung zur Simulation der elektrischen Spannung einer ersten Batteriezelle
und mit einer Steuerelektronik zur Regelung der ersten Zellspannung,
**dadurch gekennzeichnet, dass** die erste Zellspannung auf eine lokale Schaltungsmasse gelegt ist;
eine von der Steuerelektronik geregelte, über einen zweiten Teilabschnitt der ersten elektrischen Schaltung abfallende zweite Zellspannung zur Simulation der elektrischen Spannung einer zweiten Batteriezelle auf dieselbe lokale Schaltungsmasse gelegt ist; und
die zweite Zellspannung zu der ersten Zellspannung derart in Reihe geschaltet ist, dass die lokale Schaltungsmasse einen Pol der ersten Zellspannung und der zweiten Zellspannung ausbildet.

2. Batteriesimulator gemäß Anspruch 1, die erste elektrische Schaltung umfassend:
eine Spannungsquelle, die angeordnet ist, eine Versorgungsspannung für den Betrieb der elektrischen Bauelemente der ersten elektrischen Schaltung an die erste elektrische Schaltung anzulegen;
einen von der Versorgungsspannung gespeisten ersten Spannungsregler, der angeordnet und ausgestaltet ist, die erste Zellspannung an den ersten Teilabschnitt anzulegen und auf einen ersten Sollwert zu regeln;
einen von der Versorgungsspannung gespeisten Inverswandler, der zu dem ersten Spannungsregler parallelgeschaltet ist;
einen von der Ausgangsspannung des Inverswandlers gespeisten zweiten Spannungsregler, der angeordnet und ausgestaltet ist, die zweite Zellspannung an den zweiten Teilabschnitt anzulegen und auf einen zweiten Sollwert zu regeln;
wobei die Steuerelektronik eingerichtet ist, dem ersten Spannungsregler den ersten Sollwert derart vorzugeben, dass der erste Sollwert gleich einer Sollvorgabe für die elektrische Spannung der ersten Batteriezelle ist
und dem zweiten Spannungsregler den zweiten Sollwert derart vorzugeben, dass der zweite Sollwert gleich dem Negativwert einer Sollvorgabe für die elektrische Spannung der zweiten Batteriezelle ist.

3. Batteriesimulator gemäß einem der Ansprüche 1 oder 2, umfassend eine identisch zur ersten elektrischen Schaltung ausgestaltete zweite elektrische Schaltung zur Bereitstellung einer dritten Zellspannung zur Simulation der elektrischen Spannung einer dritten Batteriezelle und einer vierten Zellspannung zur Simulation der elektrischen Spannung einer vierten Batteriezelle,
die mit der ersten elektrischen Schaltung derart elektrisch verbunden ist, dass die erste Zellspannung, die zweite Zellspannung, die dritte Zellspannung und die vierte Zellspannung in Reihe geschaltet sind.

## Geänderte Patentansprüche

### Geänderte Patentansprüche gemäss Regel 137(2) EPÜ.

1. Batteriesimulator, umfassend eine erste elektrische Schaltung mit einer über einen ersten Teilabschnitt (10) der ersten elektrischen Schaltung abfallenden ersten Zellspannung U_{Z1} zur Simulation der elektrischen Spannung einer ersten Batteriezelle
und mit einer Steuerelektronik (22) zur Regelung der ersten Zellspannung U_{Z1} auf einen ersten Sollwert, der gleich einer Sollvorgabe für die elektrische Spannung der ersten Batteriezelle ist,
**dadurch gekennzeichnet, dass** die erste Zellspannung U_{Z1} auf eine lokale Schaltungsmasse (23) gelegt ist;
eine über einen zweiten Teilabschnitt (11) der ersten elektrischen Schaltung abfallende zweite Zellspannung U_{Z2} zur Simulation der elektrischen Spannung einer zweiten Batteriezelle auf dieselbe lokale Schaltungsmasse (23) gelegt ist;
die zweite Zellspannung U_{Z2} zu der ersten Zellspannung U_{Z1} derart in Reihe geschaltet ist, dass die lokale Schaltungsmasse (23) einen Pol der ersten Zellspannung U_{Z1} und der zweiten Zellspannung U_{Z2} und ein gemeinsames Nullpotential für die erste Zellspannung U_{Z1} und die zweite Zellspannung U_{Z2} ausbildet; und
die Steuerelektronik (22) eingerichtet ist, die zweite Zellspannung U_{Z2} auf einen zweiten Sollwert zu regeln, der gleich dem Negativwert einer Sollvorgabe für die elektrische Spannung der zweiten Batteriezelle ist.

2. Batteriesimulator gemäß Anspruch 1, die erste elektrische Schaltung umfassend:
eine Spannungsquelle (4), die angeordnet ist, eine Versorgungsspannung für den Betrieb der elektrischen Bauelemente der ersten elektrischen Schaltung an die erste elektrische Schaltung anzulegen;
einen von der Versorgungsspannung gespeisten ersten Spannungsregler (6) , der angeordnet und ausgestaltet ist, die erste Zellspannung U_{Z1} an den ersten Teilabschnitt (10) anzulegen und auf einen ersten Sollwert zu regeln;
einen von der Versorgungsspannung gespeisten Inverswandler (24), der zu dem ersten Spannungsregler (6) parallelgeschaltet ist;
einen von der Ausgangsspannung des Inverswandlers (24) gespeisten zweiten Spannungsregler (7), der angeordnet und ausgestaltet ist, die zweite Zellspannung U_{Z2} an den zweiten Teilabschnitt (11) anzulegen und auf einen zweiten Sollwert zu regeln;
wobei die Steuerelektronik (22) eingerichtet ist, dem ersten Spannungsregler (6) den ersten Sollwert derart vorzugeben, dass der erste Sollwert gleich einer Sollvorgabe für die elektrische Spannung der ersten Batteriezelle ist
und dem zweiten Spannungsregler (7) den zweiten Sollwert derart vorzugeben, dass der zweite Sollwert gleich dem Negativwert einer Sollvorgabe für die elektrische Spannung der zweiten Batteriezelle ist.

3. Batteriesimulator gemäß einem der Ansprüche 1 oder 2, umfassend eine identisch zur ersten elektrischen Schaltung ausgestaltete zweite elektrische Schaltung zur Bereitstellung einer dritten Zellspannung zur Simulation der elektrischen Spannung einer dritten Batteriezelle und einer vierten Zellspannung zur Simulation der elektrischen Spannung einer vierten Batteriezelle,
die mit der ersten elektrischen Schaltung derart elektrisch verbunden ist, dass die erste Zellspannung, die zweite Zellspannung, die dritte Zellspannung und die vierte Zellspannung in Reihe geschaltet sind.
